Europäisches Patentamt

European Patent Office

Office européen des brevets

(11) Publication number: **0 125 016**
**B1**

(12) **EUROPEAN PATENT SPECIFICATION**

(45) Date of publication of patent specification: **10.10.90**

(51) Int. Cl.⁵: **G 01 J 1/04**

(21) Application number: **84302329.2**

(22) Date of filing: **05.04.84**

(54) Optical shields for optical sensing devices.

(30) Priority: **07.04.83 JP 61753/83**
**07.04.83 JP 61754/83**
**08.04.83 JP 62659/83**

(43) Date of publication of application:
**14.11.84 Bulletin 84/46**

(45) Publication of the grant of the patent:
**10.10.90 Bulletin 90/41**

(84) Designated Contracting States:
**DE FR GB**

(56) References cited:
**EP-A-0 063 694**
**EP-A-0 068 456**
**FR-A-2 135 219**
**US-A-3 105 428**

**PATENT ABSTRACTS OF JAPAN, vol. 6, no. 245**
**(P-159)1123r, 3rd December 1982; & JP - A - 57**
**142 526**

(73) Proprietor: **FUJITSU LIMITED**
**1015, Kamikodanaka Nakahara-ku**
**Kawasaki-shi Kanagawa 211 (JP)**

(72) Inventor: **Miyamoto, Yoshihiro c/o Fujitsu**
**Limited**
**Patent Department 1015 Kamikodanaka**
**Nakahara-ku**
**Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

EP 0 125 016 B1

Courier Press, Leamington Spa, England.

## Description

The present invention relates to optical sensing devices and more particularly to optical shields for optical sensing devices.

One form of optical sensing device is an infrared image sensing device or IR detector.

In an IR detector, impinging infrared energy is converted into electrical energy proportionally, by an array of semiconductor sensing elements (hereinafter called simply 'sensing elements'), which works well at an extremely low temperature such as 77K, for example. The sensing elements of the array are arranged in a line or over an area usually square or rectangular in shape. IR energy emitted from an object to be observed and within a field of view is focused on the array by optical collecting lenses, being filtered through an infrared filter window. The focused IR image is converted into electrical signals and processed, using electronic apparatus, for display on a display device such as the screen of a cathode ray tube.

IR emission or radiation from an object varies sharply with the temperature of the object. A detectable temperature difference between an object and its background, or between a portion of interest on an object and another portion of the object, can be expected to be as small as 0.1 to 0.2°C.

Recently, the sensitivity of IR sensing elements has been improved markedly and the sensitivity of individual elements has become sufficiently uniform as to allow the extraction of a clear image of an object. As the result, signal/noise ratio has become a source of serious problems which must be solved if a high grade image is to be obtained.

One source of noise is extraneous photons intruding from outside the (desired or ideal) field of view (hereinafter called the "FOV") of an IR sensing array. For the purpose of reducing such noise, an optical (or heat) shield is set in front of the IR array to shield it from extraneous IR energy and to reject extraneous photons by restricting the solid angle corresponding to the FOV.

To obtain a high grade image, a uniform distribution of impinging IR energy over the IR elements is necessary; that is, each element should have the same inherent capacity or opportunity to receive impinging energy—the device should not have a structure such that some elements are more or less favourably placed to receive energy than others. With a previously proposed shield, the problem of obtaining such a distribution has been left unsolved. Non-uniformity of distribution is called 'shading' and usually occurs in relation to marginal portions of an image.

Generally, the solid angle of the FOV of an array is defined by the ratio between the size of an aperture in the optical shield and the distance between the IR array and the shield. Previously, an optical shield has had a single aperture through which the incoming IR energy is projected, and the size of the aperture is large.

Therefore, the distance between the IR array and the shield necessary to achieve a desired FOV solid angle has been large in proportion to the size of the aperture. This has prevented miniaturization of the previous IR detector.

Previous IR sensing elements have used IR sensing semiconductor materials such as mercury-cadmium-telluride, whose operating temperature is very low, as indicated above. The array has been attached tightly, with low heat resistance, to a base plate of a high thermal conductivity material such as copper, and has been insulated thermally from the external environment by means of a vacuum chamber (Dewar vessel). The array has been cooled through the base plate by a refrigerator arranged outside the Dewar vessel.

Sometimes the optical shield is called the cold shield, because the shield should be kept cold to reduce IR radiation from the shield itself, which might form another source of noise.

IR energy emitted from an object to be observed or measured, collected by a positive lens, and filtered through an IR filtering window, impinges onto the surface of the array, the FOV being restricted by the shield aperture.

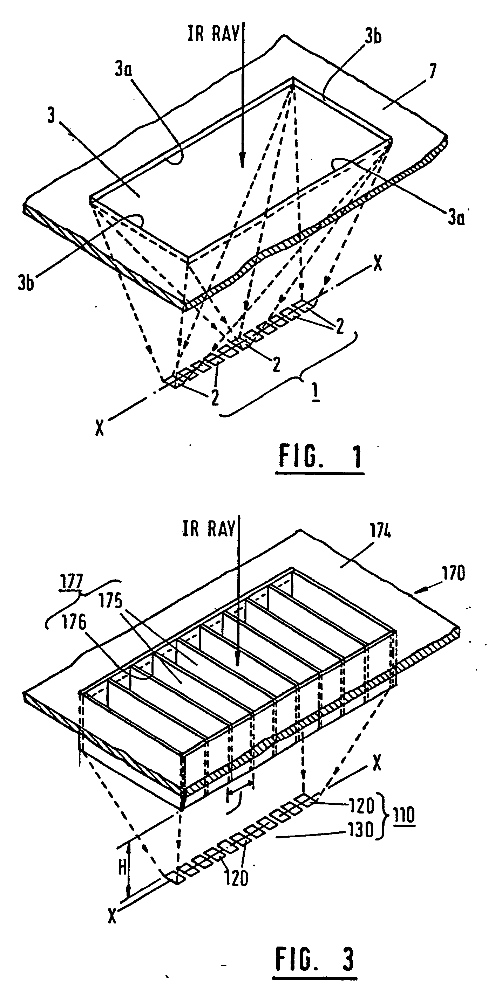

As shown in Fig. 1 in a schematic perspective view, an optical shield 7 has a single aperture 3 (opening window) formed in dependence upon the shape of the array. For example, for a linear array 1 of IR elements 2, a rectangular aperture 3 is provided. Apparently, sides 3a of the rectangular window 3 parallel to the linear array 1 shield the sensing elements effectively from extraneous photons from outside the FOV angle, but the other sides 3b of the window transverse to the linear array 1, do not shield the array 1 effectively. It is clear that the distribution of IR energy impinging onto the elements 2 is not uniform along the axis X—X of the linear array 1, the distribution having a peak at the center and somewhat of a reduction at both ends of the array. This is called 'shading'. Naturally, this will result in an IR image with speckles and partially faded background. As mentioned above, the temperature difference to be detected is very small, so such noise and shading will seriously affect the image quality of the IR detector.

A counter-measure has been proposed in US patent 4,027,160, in which an array of individual optical shields fabricated by semiconductor technology is disclosed. The advantage of this type of shield is that each IR sensing element is surrounded by a shielding section of the shielding array, so the shielding itself is performed individually in respect of each sensing element. This means the number of sensing elements is exactly the same as the number of the optical shield elements. By such a shielding 'shading' is eliminated almost completely.

However, as semiconductor technology progresses, the pitch of sensing elements on an array is becoming smaller, for example as little as several tens of micrometers, so there remains little space between the sensing elements in which set individual shields surrounding each individual element. In other words, the pitch of the sensing elements of the IR array is limited by the provision of individual shields. This results in a restriction on the resolution power of IR imaging apparatus.

Previous proposals, and problems arising with those proposals have been described above in connection with IR image sensing devices. However, similar considerations apply also to other types of optical sensing devices.

Attention is directed to EP—A2—0 063 694 which discloses an optical sensing device having an array of optical energy sensing elements and an optical shield having a cellular or grid-like structure defining openings, divided each from another by a wall, for the passage of optical energy to the array.

Attention is also directed to FR—A—2 135 219.

According to the present invention there is provided an optical sensing device, comprising:—

an array of optical energy sensing elements; and

an optical shield, spaced apart from the array, defining a field of view for the array, the optical shield having a cellular or grid-like structure defining openings, divided each from another by a wall, for the passage of optical energy to the array,

characterised in that the solid angle of view of each sensing element is defined through a plurality of the openings of the optical shield.

An embodiment of the present invention can provide an optical image sensing device giving a high quality image signal.

An embodiment of the present invention can provide an IR detector with a high signal to noise ratio and practically no shading effect of an IR image.

An embodiment of the present invention can provide an improved optical shield structure for an IR detector, which shields an IR array from extraneous IR energy intruding from outside the FOV solid angle of the array, and provides a uniform or more uniform distribution of impinging IR energy over IR sensing elements of the IR array.

An embodiment of the present invention can provide a compact and less costly IR detector head.

In an embodiment of the present invention an optical shield has a grid-like or cellular structure having a plurality of apertures (opening windows).

In an IR detector embodying the present invention, an optical shield is of grid-like or cellular structure having a plurality of shield elements, like cells. The shield is supported in front of an IR sensing element array, in parallel to the array, at a specified distance H from the array, and is cooled through an outer frame of the shield attached to a base plate.

The total IR energy incident on each IR sensing element is limited by the solid angle of the field of view as seen from the IR sensing element concerned. The angle is determined or restricted by the geometry of the shield and the distance H between the array and the shield. If the shield element area of the optical shield is sufficient to cover the array, the solid angle of the field of view becomes the same, practically, for each IR element, resulting in uniform distribution of the impinging IR energy on the sensing elements and mitigating or avoiding 'shading' of the IR image.

The number of the shield elements need not be the same as the number of IR sensing elements, because each IR sensing element is not shielded individually, although the elements each have practically the same FOV.

This affords a remarkable advantage for the present invention because it allows great freedom for the design and fabrication of the shield.

It will be understood that, although the description above and below is given mainly with regard particularly to IR imaging sensing devices, the invention can be applied to other optical sensing devices, such as X-ray sensing devices, ultraviolet sensing devices and visible light sensing devices for example.

Reference is made, by way of example, to the accompanying drawings, in which:—

Fig. 1 is a schematic perspective view showing the optical shield of a previously proposed IR detector, with an associated linear IR sensing element array, illustrating the solid angle of field of view (FOV) as seen from each sensing element,

Fig. 2 is a schematic cross-sectional front elevational view of an infrared detector embodying to the present invention, particulary illustrating the construction of an optical shield of the detector,

Fig. 3 is a schematic perspective view showing the optical shield of an embodiment of the present invention, with an associated linear IR array, illustrating the solid angle of FOV as seen from each sensing element,

Fig. 4 is a schematic cross-sectional view of an example of a head of an infrared detector embodying the present invention, illustrating the optical system of the head and a collecting lens,

Figs. 5(a) and (b) are diagrams illustrating the optical geometry of an object and its image with the optical system of the previously proposed IR detector of Fig. 1,

Figs. 6(a) and (b) are diagrams illustrating the optical geometry of an object and its image with an IR detector embodying the present invention, for explanation of a critical FOV solid angle as seen from the IR array of the detector,

Fig. 7 is a schematic illustration of the geometry of the optical shield-image sensing element array arrangement of an embodiment of the present invention,

Fig. 8 is a schematic perspective view of the optical shield, for a linear sensing element array, of another embodiment of the present invention,

Fig. 9 is a schematic perspective view of the optical shield, for an area sensing element array, of another embodiment of the present invention, and

Figs. 10(a), (b) and (c) are schematic diagrams of examples of optical shields of further embodiments of the present invention.

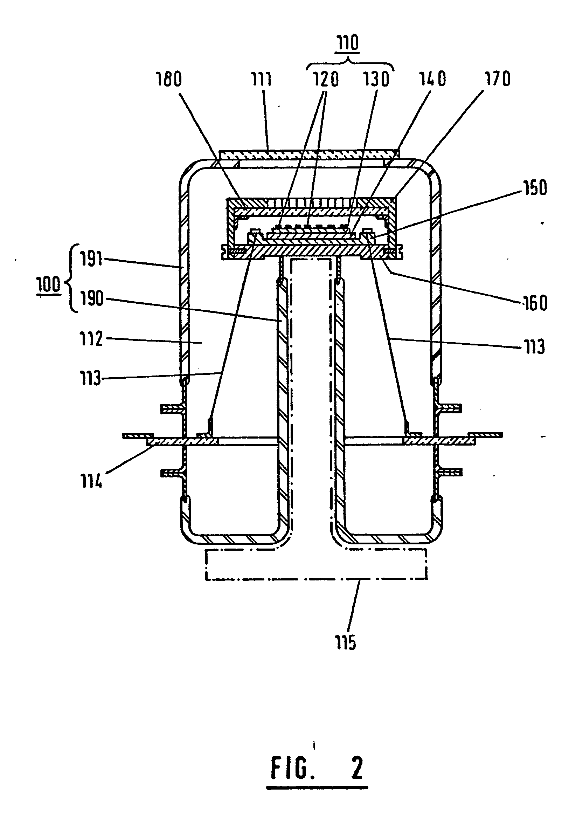

Referring to the cross-sectional view of the structure of an IR detector embodying the present invention given in Fig. 2, an IR sensing array 110 has several sensing elements 120 arranged in a line (linear array) or over an area (area array) and is attached to a base plate 160. The sensing elements 120 are formed in a substrate 130 of IR sensing semiconductor material such as mercury-cadmium-telluride. The substrate 130, being set on a sapphire plate 140 and a ceramic terminal plate 150 is attached to the base plate 160 (or cooling plate) which is mounted on the stem of a Dewar vessel 100. An optical shield 170, provided in accordance with the present invention, is attached to the base plate 160, which is cooled by a refrigerator 115. An IR filter disc 180 is placed inside the shield 170.

There is thus provided an IR sensing head which is thermally insulated from the environment in a vacuum enclosed by an inner glass envelope 190 (stem) of the vessel 100, an outer glass envelope 191 of the vessel 100, an IR window 111 and so on. The envelopes have metal members and a multi terminal ceramic disc 114, being sealed to the glass envelope members to form a space 112, which is evacuated in the final stage of fabrication of the IR detector. Electrical signals from sensing elements 120 are transmitted through the lead wires 113 and lead terminals (not shown) radially formed on the surface of the ceramic multi terminal disc 114 by a conventional printing method of hybrid IC technology.

Incoming IR energy (ray) is collected by a collecting lens (not shown) and focused on the array 110 passing through IR window 111 and IR filter 180. The optical shield 170 limits the solid angle of the FOV (optical field of view) to shield the array 110 from extraneous IR energy as described above.

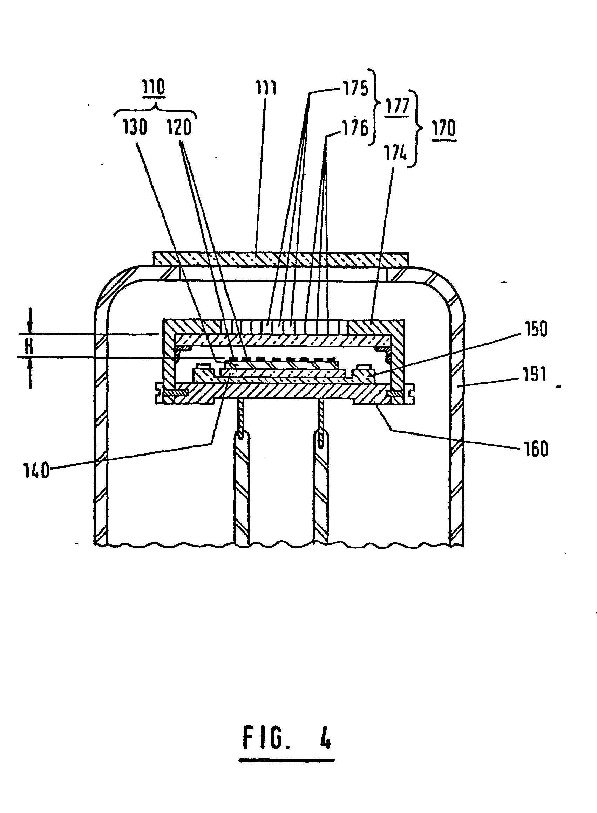

The optical shield 170 employed in the embodiment of the present invention of Fig. 2 is illustrated in the schematic perspective view of Fig. 3.

As can be seen, the optical shield 170 has a cellular structure with several small openings 175 separated by partition walls 176. The openings 175 are surrounded by partition walls 176 and an outer frame 174, to constitute shield elements or cells 177. The partition wall height extends generally upstream-downstream with respect to optical energy (IR Ray) passing to the array, in this case perpendicular to the array. Partition wall lengths extend along lines transverse to the line of the array.

In Fig. 4, a schematic sectional view of the optical shield 170 is given. The shield elements 177 are arranged on one plane which is placed in front of the array 110 in parallel to the array at a distance H from the array. For the same FOV solid angle, the distance H can be made much smaller than the array-shield distance needed with the previous arrangement of Fig. 1. This allows miniaturization of the IR detector embodying the present invention.

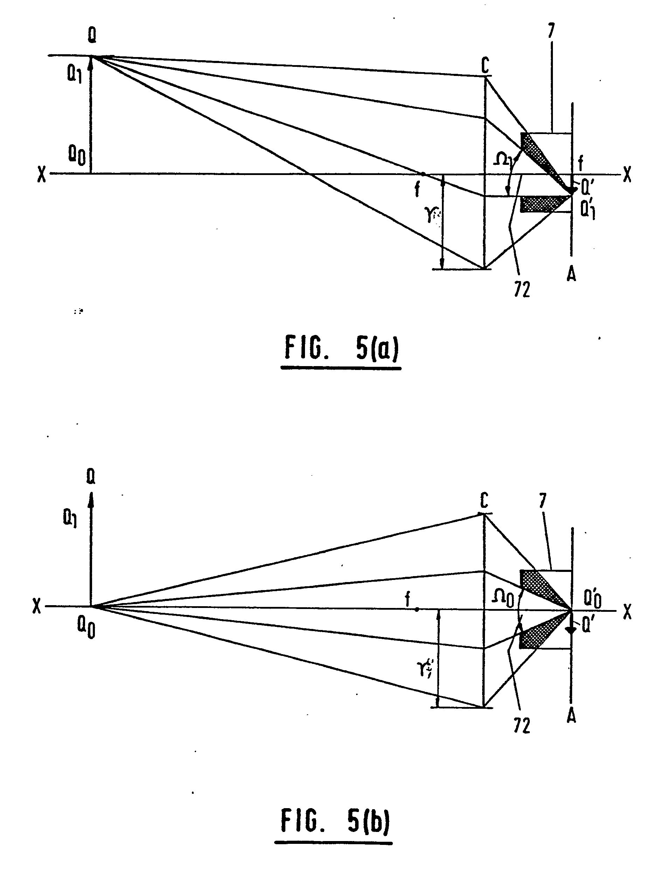

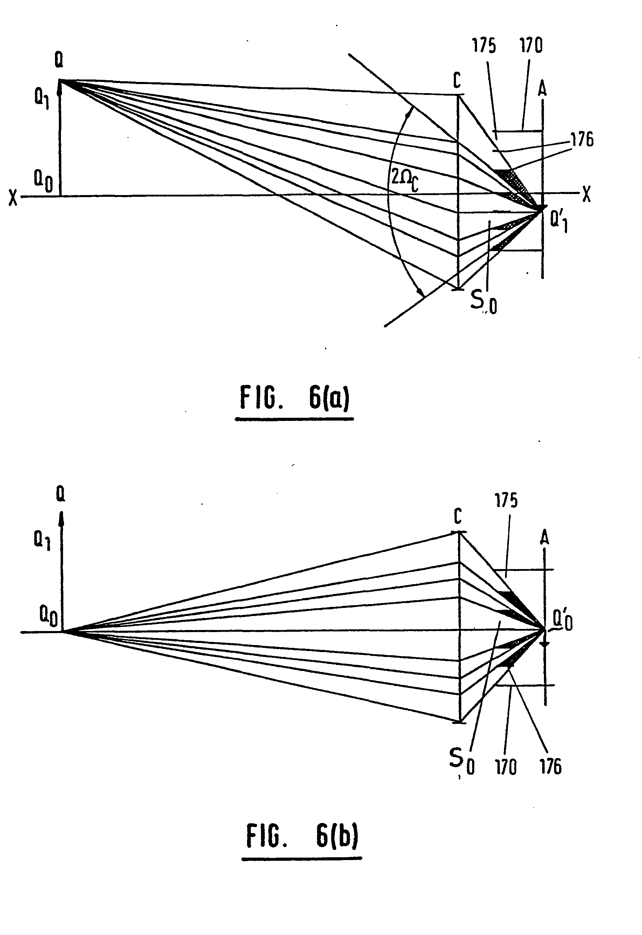

To facilitate understanding, some optical geometric descriptions will be given referring to Fig. 5 and Fig. 6, which relate respectively to optical paths in the optical system for the previous IR detector of Fig. 1 and in an IR detector embodying the present invention.

In Fig. 5(a), a collecting lens C forms an image $Q'$ of an object $Q$ on a focal plane A, where an IR array is placed. Some rays originating from an object point $Q_1$ are shielded by the single aperture optical shield 7 as previously used (see Fig. 1) but other rays (passing through the aperture 3 in the shield) can reach the array. The quantity of the rays reaching the array is proportional to the FOV solid angle $\Omega_1$ subtended to the point $Q'_1$ (at which object point $Q_1$ is imaged). In Fig. 5(b), the object point $Q_0$, positioned on optical axis X—X, is imaged at $Q_0'$ and the FOV solid angle subtended to the point $Q_0'$ is $\Omega_0$. Thus there can be taken various FOV solid angles 72 as seen from corresponding points of image $Q'$ on the focusing plane, or IR array plane. Apparently, $\Omega_0$ is the largest such angle and $\Omega_1$ is the smallest. Thus, intensity distribution on the image $Q'$ has a convex profile form. The non-uniformity of the distribution is called the 'shading' effect.

Figs. 6(a) and (b) concern the optical system provided when an optical shield 170 is employed in accordance with an embodiment.

Object points $Q_1$ and $Q_0$ are imaged at the points $Q_1'$ and $Q_0'$ respectively. As described before, the aperture in the optical shield 170 is provided by several shield elements 177, that is, a group of small apertures or cells. The FOV solid angle viewed from a sensing element at the point $Q_1'$ is the sum of a plurality of solid angles which are defined by the individual shield elements 177. Hereinafter such separated solid angles corresponding to the individual shield elements will be called FOV sub-solid angles. Considering the FOV solid angle viewed from an IR sensing element at $Q_1'$, as is easily seen from Fig. 6(a), the sub-solid angle of a shield element $S_0$ which is located immediately above the sensing point $Q_1'$ will be the largest such angle and the sub-solid angles for other shield elements will decrease as the shield elements are located further away from the shield element $S_0$. Further, there is a critical angle with regard to the direction of a shield element as viewed from the sensing element at $Q_1'$ beyond which the sub-solid angle will disappear (the sub-solid angles for sensing elements remote from the sensing element at $Q_1'$ will be zero). The angle between the normal to the array plane and the critical direction described above will be defined as FOV critical solid angle $\Omega_C$.

In the case shown in Fig. 6(b), the object point $Q_0$ has its image at the point $Q_0'$ and the FOV solid angle (the sum of FOV sub-solid angles as seen from the sensing element at the point $Q_0'$)

is the same as the FOV solid angle as seen by the sensing element at point $Q_1'$ (see Fig. 6(a)).

Assuming that the shield elements are arranged in the plane of the optical shield and extend beyond the critical angle of the confronting IR sensing array (strictly speaking, beyond the critical solid angles of each of the sensing elements positioned at marginal points (ends) of the array), the FOV solid angle, that is, the sum of FOV sub-solid angles, as seen from each sensing element, is the same for each sensing element. So, it can be said that, in this case, there is no 'shading' effect theoretically.

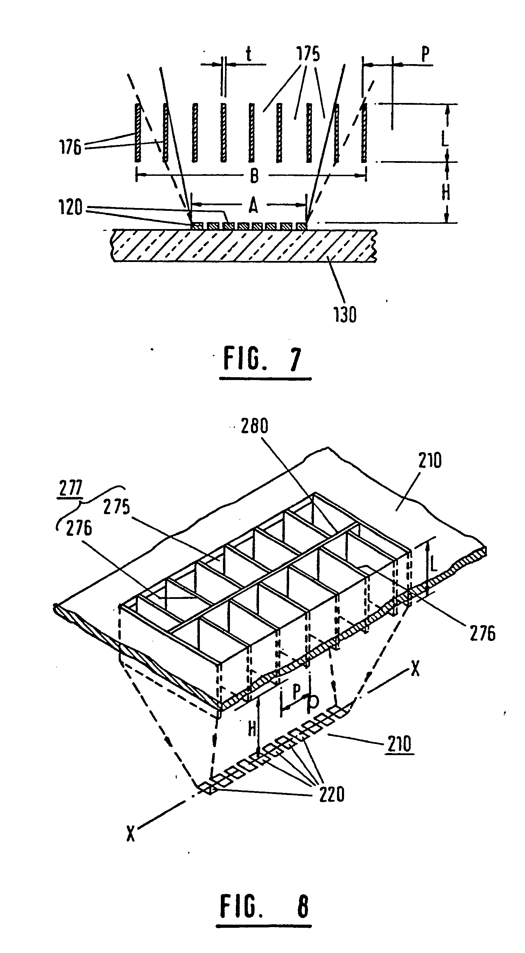

The FOV solid angle viewed from the IR sensing elements is defined by distance H, depth (dividing wall height) L and pitch P of the shield elements, and the total length A of the array A and the total length B of shield apertures (opening length of the shield) as illustrated in Fig. 7 schematically, and the law of similarity is applicable.

Incoming IR energy distribution onto sensing elements of a linear array was calculated using, for simplicity, the two dimensional optical geometric model as shown in Fig. 7. The results are also applicable to an optical shield for an area array. Calculations were performed for several combinations of the dimensions H, L, A, P and the wall thickness t of partition walls. These dimensions are expressed in terms of relative lengths. Calculations were also performed for the previous proposal of Fig. 1, for comparison.

The ratios $\alpha$ of minimum value to the maximum value of the IR energy distribution were found to be as follows.

For the previous proposal of Fig. 1
    For A=20, B=20, H=20; $\alpha$=0.791
    For A=20, B=20, H=40; $\alpha$=0.922

For an embodiment of the present invention as illustrated in Fig. 7
    For A=20, B=30, H=5; $\alpha$=0.992
    with P=1, t=0.1, L=0.7

It is clear from this that an embodiment of the present invention can provide a very uniform distribution of impinging IR energy on an IR sensing array, and that the distance H can be made small, allowing the miniaturization of an IR detector.

Some further examples of optical shield structures of embodiments of the present invention will now be described.

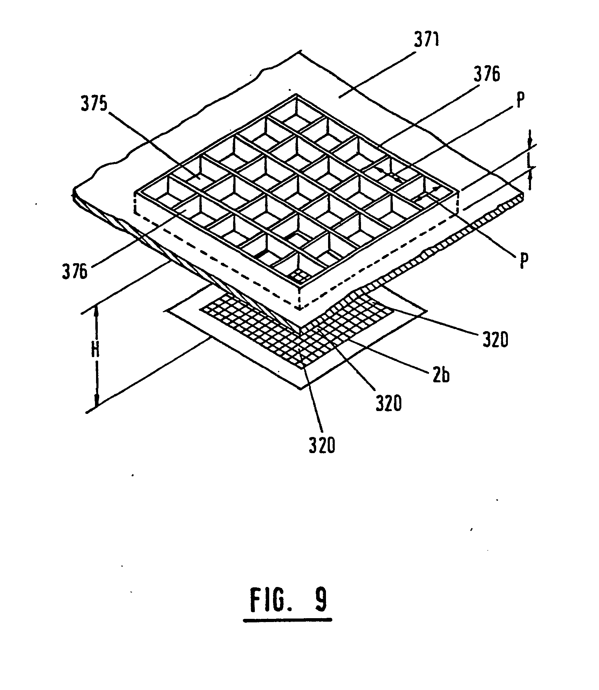

A modified form of the shield structure of Fig. 3 is illustrated in Fig. 8. A common feature of the optical shield structures of Figs. 3 and 8 is that partition walls 176 or 276 are arranged perpendicularly of the surface in which the array is arranged, and that the partition walls are directed across the axis X—X of the linear array 110 or 210.

The optical shield structure shown in Fig. 8 has two adjoining trains of shield elements 277 or cells, each train of the same structure, side by side, (their common side wall is denoted by 280 in Fig. 8) with a half-pitch difference between the dispositions of their walls 276. This difference improves the uniformity of the distribution of impinging IR energy on the array. With the construction shown in Fig. 8, the difference between the maximum and the minimum value of the energy distribution is reduced by about a half in comparison with a structure as shown in Fig. 3 having a single train of shield elements or cells.

The principle mentioned above for a linear array can be easily extended to a two dimensional array, that is, an area array. An example of an optical shield for an area array 320 is shown schematically in the perspective view of Fig. 9. The optical geometric observation is abbreviated. A grid-like or cellular structure is seen in Fig. 9, each cell being separated from the others by partition walls 376 to provide an individual shield element 375. The partition walls are arranged perpendicularly to the plane of the area array 320. The area of grid-like structure of the optical shield confronting the area array 320 at a distance H, is desirably such that the structure extends beyond the FOV solid angle of the area array 320 so as to obtain a more uniform IR energy distribution.

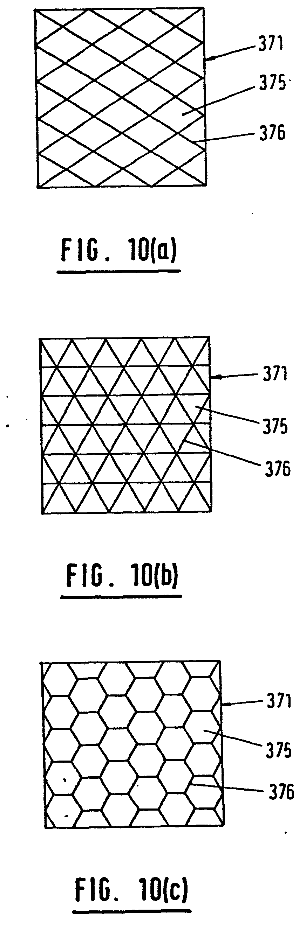

Various possible modifications of the form of cellular structure of a shield for an area array are illustrated in Fig. 10. The shape of each individual shield element or cell may be square, rectangular, triangular, hexagonal, parallelogrammatical, trapezoidal, etc, depending on the available fabricating technology and necessary shielding function of the optical shield. Figs. 10(a), (b) and (c) illustrate shield elements with a parallelogram shape, triangular shape and a honey-comb arrangement respectively.

For fabrication of the optical shield, especially the shield element structure, various conventional technologies are available and should be selected according to the precision and accuracy required.

For example, when the FOV solid angle for the IR array is required relatively large, the pitch P of the shield elements can be as much as 1 mm or so, more than ten times the pitch of IR sensing elements, and the partition walls of the shield can be fabricated from a thin metal sheet by a conventional etching method such as is used for fabricating a metal mask in a semiconductor fabrication process, and can be assembled together with an outer frame by soldering. Of course, the partition can be punched out also by conventional precise punching work.

To fabricate an optical shield of a finer dimension such as 100 µm, a conventional working method utilizing electrical discharge working or laser working is available.

The surfaces of the partition walls of the shield elements should have a high emissivity, so as to absorb IR energy striking the wall surfaces, in order to avoid multi-reflection. For this purpose also conventional methods are applicable, depending on the materials of which the partition walls are made. For example, for stainless steel, an oxidizing method is useful. The oxidation is effected by heating the material in a hydrogen furnace in a moist hydrogen atmosphere. For aluminium, a conventional electro-chemical method, anodic oxidation, is applied to form a dull partition wall surface. Other methods, such as a sooting method, are applicable. The emissivity should be higher than 0.5, and this value is attainable by the above-described methods.

Above, embodiments of the present invention have been described in relation to infrared detection. However, it is easily understood that embodiments of the present invention can be applied to other optical sensing devices such as X-ray sensing devices, ultraviolet sensing devices, visible light optical sensing devices and the like.

An optical image sensing device embodying the present invention can be provided comprising:

an array of optical energy semiconductor sensing elements mounted in the path of the field of view for producing electrical signals corresponding to said optical energy impinging thereon; and

an optical shield for shielding said array from extraneous optical energy, and distributing said optical energy uniformly to each sensing element of said array,

said optical shield is located in front of said array in parallel keeping a specified distance from said array, and has a grid-like or cellular structure with a plurality of adjacent shield elements having specified depth, being separated each other by a plurality of partition walls which are arranged perpendicular to the surface of said array,

said partition walls cross a line of the sensing elements of said array,

said optical shield has a supporting means surrounding said grid-like or cellular structure.

The array may be a linear array of infrared semiconductor sensing elements attached to a base plate and cooled to the specified operating temperature;

said optical shield having a train of adjacent shield elements with specified depth being separated each other by a plurality of partition walls,

said walls being arranged perpendicularly to the surface of said linear array, and

said supporting means being attached to said base plate.

The array may be an area array of infrared semiconductor sensing elements attached to a base plate and cooled to the specified operating temperature;

said optical shield having a two-dimensional grid-like or cellular structure of adjacent shield elements having specified depth being separated from each other by a plurality of partition walls,

said walls being arranged perpendicularly to the surface of said area array, and

said supporting means being attached to said base plate.

An embodiment of the present invention can provide an opto electronic device comprising:

an array of infrared energy sensing elements which are cooled to their operating temperature,

an optical cold shield having a plurality of apertures which define the solid angle of the field of view of said sensing elements,

said optical cold shield is supported in from of the said array keeping a distance H from said array,

said apertures are separated by a plurality of partition walls,

said partition walls are arranged perpendicularly to the surface of said array and so as to cross the arranged line of said sensing elements, and

said solid angle of field of view of said sensing elements is defined by the geometry of said optical cold shield such as the depth and the pitch of said aperture and said distance H between said sensing array and said optical cold shield.

## Claims

1. An optical sensing device, comprising:—
an array (110, 210, 310) of optical energy sensing elements (120, 220); and
an optical shield (170, 270, 371), spaced apart from the array, defining a field of view for the array, the optical shield having a cellular or grid-like structure defining openings (175, 275, 375), divided each from another by a wall (176, 276, 280, 376), for the passage of optical energy to the array (110, 210),
characterised in that the solid angle of view of each sensing element (120, 220) is defined through a plurality of the openings (175, 275, 375) of the optical shield (170, 371).

2. A device as claimed in claim 1, wherein dividing wall height extends generally upstream-downstream with respect to optical energy passing to the array (110, 210, 320) when the device is in use.

3. A device as claimed in claim 1 or 2, wherein dividing wall length extends along a line or lines which traverse a line of sensing elements (120, 220) in the array.

4. A device as claimed in claim 1, 2 or 3, wherein the optical shield (170, 270, 371) is disposed in parallel to the array (110, 210, 320).

5. A device as claimed in claim 1, 2, 3 or 4, wherein the openings (175, 275, 375) of the optical shield differ in number from the optical energy sensing elements (120, 220) of the array (110, 210, 320).

6. A device as claimed in any preceding claim, wherein the openings (175, 275, 375) of the optical shield are square, or rectangular or triangular or hexagonal or trapezoidal or parallelogramatical in form.

7. A device as claimed in any preceding claim, wherein dividing wall surface emissivity for rays of the optical energy sensed by the elements (120, 220) of the array (110, 210, 320) is greater than 0.5.

8. A device as claimed in any preceding claim, wherein the cellular structure of the optical shield (170, 270, 371) extends beyond the field of view solid angle of the array (110, 210, 320).

9. A device as claimed in any preceding claim, wherein the array (110, 210) is a linear array of infrared semiconductor sensing elements, and the openings (175, 275) of the optical shield are arranged in a line or lines in front of the array.

10. A device as claimed in any one of claims 1 to 8, wherein the array (320) is a two-dimensional array of infrared semiconductor sensing elements, and the openings (375) of the optical shield are arranged in a two-dimensional pattern.

**Patentansprüche**

1. Optische Fühlvorrichtung, mit:—
einer Anordnung (110, 210, 320) von optischen Energiefühlelementen (120, 220); und
einem optischen Schirm (170, 270, 371), der mit Abstand von der Anordnung angeordnet ist und ein Gesichtsfeld für die Anordnung definiert, welcher optische Schirm eine zellulare oder gitterartige Struktur hat, die Öffnungen (175, 275, 375) definiert, die jeweils voneinander durch eine Wand (176, 276, 280, 376) getrennt sind, für den Durchgang der optischen Energie durch die Anordnung (110, 210),
dadurch gekennzeichnet, daß der räumliche Sichtwinkel von jedem Fühlelement (120, 220) durch eine Vielzahl von Öffnungen (175, 275, 375) des optischen Schirms (170, 371) definiert ist.

2. Vorrichtung nach Anspruch 1, bei der die Trennwandhöhe sich im allgemeinen stromaufwärts-stromabwärts in Bezug auf die optische Energie erstreckt, welche durch die Anordnung (110, 210, 320) hindurchtritt, wenn die Vorrichtung in Betrieb ist.

3. Vorrichtung nach Anspruch 1 oder 2 bei der die Trennwandlänge sich längs einer Reihen oder Reihen erstreckt, welche quer zu einer Reihe von Fühlelementen (120, 220) in der Anordnung angeordnet sind.

4. Vorrichtung nach Anspruch 1, 2 oder 3, bei der der optische Schirm (170, 270, 371) parallel zu der Anordnung (110, 210, 320) angeordnet ist.

5. Vorrichtung nach Anspruch 1, 2, 3 oder 4, bei der die Öffnungen (175, 275, 375) des optischen Schirms sich in ihrer Zahl von den optischen Energiefühlelementen (120, 220) der Anordnung (110, 210, 320) unterscheiden.

6. Vorrichtung nach einem der vorhergehenden Ansprüche, bei der die Öffnungen (175, 275, 375) des optischen Schirms quadratisch, rechtwinklig, dreieckig, hexagonal, tapezförmig oder als Parallelogramm geformt sind.

7. Vorrichtung nach einem der vorhergehenden Ansprüche, bei dem die Trannwandoberflächenemissivität für Strahlen der optischen Energie, die durch die Elemente (120, 220) der Anordnung (110, 210, 320) gefühlt wird, größer als 0,5 ist.

8. Vorrichtung nach einem der vorhergehenden Ansprüche, bei der die zellulare Struktur des optischen Schirms (170, 270, 371) sich über das Feld des räumlichen Sichtwinkels der Anordnung (110, 210, 320) erstreckt.

9. Vorrichtung nach einem der vorhergehenden Ansprüche, bei der die Anordnung (110, 210) eine lineare Anordnung von infrarotempfindlichen Halbleiterfühlelementen ist, und die Öffnungen (175, 275) des optischen Schirms in einer Reihe oder Reihen vor der Anordnung angeordnet sind.

10. Vorrichtung nach einem der Ansprüche 1 bis 8, bei der die Anordnung (320) eine zweidimensionale Anordnung von infrarotempfindlichen Halbleiterfühlelementen ist, und die Öffnungen (375) des optischen Schirms in einem zweidimensionalen Muster angeordnet sind.

**Revendications**

1. Dispositif de détection optique, comprenant:
un réseau (110, 210, 320) d'éléments de détection d'énergie optique (120, 220); et
un écran optique (170, 270, 371), écarté du réseau, définissant un champ d'observation pour le réseau, l'écran optique possédant une structure cellulaire ou du type grille qui définit des ouvertures (175, 275, 375), séparées les unes vis-à-vis des autres par des parois (176, 276, 280, 376), servant à faire parvenir l'énergie optique au réseau (110, 210),
caractérisé en ce que l'angle solide d'observation de chaque élément de détection (120, 220) est défini par l'intermédiaire de plusieurs des ouvertures (175, 275, 375) de l'écran optique (170, 371).

2. Dispositif selon la revendication 1, où la hauteur des parois de séparation s'étend sensiblement dans la direction amont-aval par rapport à l'énergie optique parvenant au réseau (110, 210, 320) lorsque le dispositif est en utilisation.

3. Dispositif selon la revendication 1 ou 2, où la longueur des parois de séparation s'étend suivant une ou plusieurs lignes qui traversent une ligne d'éléments de détection (120, 220) du réseau.

4. Dispositif selon la revendication 1, 2 ou 3, où l'écran optique (170, 270, 371) est disposé parallèlement au réseau (110, 210, 320).

5. Dispositif selon la revendication 1, 2, 3 ou 4, où les ouvertures (175, 275, 375) de l'écran optique ne sont pas en nombre égal à celui des éléments de détection d'énergie optique (120, 220) du réseau (110, 210, 320).

6. Dispositif selon l'une quelconque des revendications précédentes, où les ouvertures (175, 275, 375) de l'écran optique sont carrées, rectangulaires, triangulaires, hexagonales, trapézoïdales ou en forme de parallélogramme.

7. Dispositif selon l'une quelconque des revendications précédentes, où l'émittance superficielle des parois de séparation vis-à-vis des rayons de l'énergie optique détectée par les éléments (120, 220) du réseau (110, 210, 320) est supérieure à 0,5.

8. Dispositif selon l'une quelconque des revendications précédentes, où la structure cellulaire de l'écran optique (170, 270, 371) s'étend au-delà de l'angle solide du champ d'observation du réseau (110, 210, 320).

9. Dispositif selon l'une quelconque des revendications précédentes, où le réseau (110, 210) est un réseau linéaire d'éléments semi-conducteurs de détection d'infrarouge, et les ouvertures (175, 275) de l'écran ·optique sont disposées suivant une ou plusieurs lignes en avant du réseau.

10. Dispositif selon l'une quelconque des revendications 1 à 8, où le réseau (320) est un réseau bidimensionnel d'éléments semiconducteurs de détection d'infrarouge, et les ouvertures (375) de l'écran optique sont disposées suivant une configuration bidimensionnelle.

IR RAY

3b

3a

3

7

3a

3b

X

X

2

2

2

1

**FIG. 1**

IR RAY

174

170

177

175

176

X

120

110

130

120

H

X

**FIG. 3**

FIG. 2

2

FIG. 4

FIG. 5(a)

FIG. 5(b)

4

FIG. 6(a)

FIG. 6(b)

FIG. 7

FIG. 8

## FIG. 9

FIG. 10(a)

FIG. 10(b)

FIG. 10(c)